# EUROPEAN PATENT SPECIFICATION

(11) **EP 0 386 121 B1**
(45) Date of publication and mention of the grant of the patent: **01.03.1995**
(21) Application number: 88910383.4
(22) Date of filing: 10.11.1988
(51) Int. Cl.: C30B 13/00, C30B 13/24, C30B 13/32, C30B 31/12, H01L 21/00

(54) **IMPROVED ZONE MELT RECRYSTALLIZATION APPARATUS**
VORRICHTUNG ZUR ZONENSCHMELZREKRISTALLISIERUNG
APPAREIL AMELIORE DE RECRISTALLISATION PAR FUSION DE ZONE

(30) Priority: 13.11.1987 US 120015
(43) Date of publication of application: 12.09.1990
(73) Proprietor: KOPIN CORPORATION, Taunton, MA 02780 (US)
(72) Inventor: ZAVRACKY, Paul, M., Norwood, MA 02062 (US); O'CONNOR, Kevin, J., South Easton, MA 02375 (US)
(74) Representative: Greenwood, John David
(86) International application number: PCT/US88/04043
(87) International publication number: WO 89/04386

(56) References cited:
- FR-A- 2 610 450
- US-A- 4 097 226
- APPLIED PHYSICS LETTERS, vol. 41, no. 2, July 1982, New York, US; J.C. FAN et al.: "Zone-melting recrystallization of 3-in.-diam Si films on SiO2-coated Si substrates", pp. 186-188
- JOURNAL OF APPLIED PHYSICS, vol. 56, no. 10, 15 November 1984, American Institute of Physics, New York, US; S. FUJITA et al.: "Effects of heating-temperature gradient and scanning direction on crystallographic properties of zone-melting recrystallized silicon on square-shaped fused quartz", pp. 2986-2988

## Description

### Background

This invention relates generally to the conversion of amorphous or polycrystalline semiconductor materials to substantially single crystal semiconductor material by a process known as zone-melting-recrystallization (ZMR).

From transistors to very large scale integration of complex circuitry on a single chip, the field of solid state electronics has been built largely upon the abundant nonmetallic element silicon. Large diameter single crystal boules of silicon are sliced into wafers on which dopants, insulators and conductors have been applied using a variety of processes. Over the past few years, a major effort has been devoted to developing a new silicon-based technology involving the preparation of very thin films of pure single crystal silicon on the order of one-half »m thick, compared to the one-half millimeter thickness of typical silicon wafers. The new technology is described as silicon-on-insulator (SOI) technology as it utilizes a thin silicon film that is supported by an insulating substrate. An efficient, reliable and economical process for producing thin film single crystal silicon has eluded researchers.

In comparison to device performance in bulk silicon, SOI promises significant advantages:
(1) improved speed performance in discrete devices and circuits resulting from reduced parasitic capacitance;
(2) simplified device isolation and design layout, yielding potentially higher packing densities; and
(3) radiation hard circuits for space and nuclear applications.

In addition, new SOI technologies may also be utilized for three-dimensional integration of circuits.

At present, there is one mature SOI technology: silicon-on-sapphire (SOS). However, the commercial utilization of SOS has been severely limited by its high cost, relatively poor crystalline quality, and difficulty in handling and processing in comparison to bulk Si.

Recently, a new SOI technology called zone-melting recrystallization (ZMR) based on standard silicon wafers rather than sapphire crystals has exhibited the potential for displacing SOS and for utilization on a much larger scale by the semiconductor industry. The development of ZMR has been frustrated by processing problems related to the physical chemistry of the interface between the molten silicon and adjacent silicon dioxide layers which gives rise to the so-called silicon beading phenomenon during ZMR.

SOI by the ZMR technique is produced by recrystallizing a fine-grained Si film on an insulating substrate. A typical sample structure consists of a silicon wafer coated with a 1 »m thick thermally grown SiO₂ insulating layer, a half »m thick polycrystalline silicon (poly-Si) layer formed by low pressure chemical vapor deposition (LPCVD), topped by a 2 »m thick layer of SiO₂ also grown by chemical vapor deposition. The last layer forms a cover to encapsulate the polysilicon film constraining it while the film is being recrystallized.

The preparation of SOI structures by the ZMR technique is described in a paper entitled "Zone Melting Recrystallization of Silicon Film With a Moveable Strip Heater Oven" by Geis et al, J. Electrochem. Soc. Solid State Science and Technology, Vol. 129, p. 2813, 1982.

The sample is placed on a lower graphite strip and heated to a base temperature of 1100-1300°C in an argon gas ambient. Silicon has a melting point of about 1410°C; SiO₂ remains solid at the processing temperature of the system. Additional radiant energy is typically provided by a moveable upper graphite strip heater which produces localized heating of the sample along a strip to a temperature between the two melting points. Moving like a wand, the upper heater scans across the wafer to form a moving molten zone across the sample leaving a recrystallized SOI film beneath the solid SiO₂ cap.

Existing loader assemblies for placing the wafer into the heater have a number of problems. The loading arm that transports the wafer into the ZMR chamber is subjected to excessive temperatures and thus degrades rapidly when exposed to temperatures within the chamber.

According to the present invention there is provided apparatus for zone-melt recrystallization of a semiconductor wafer, comprising:
a processing chamber to zone-melt recrystallize a semiconductor wafer positioned in the chamber;
a platen within the chamber which underlies a wafer when loaded into the chamber and at least three pins within the chamber which can support the wafer therein;
a first heater to heat the wafer to a temperature below the melting temperature of the semiconductor material to be recrystallized;
a second heater to heat a portion of the wafer above said melting temperature such that a translatable melt zone is generated to continuously melt and recrystallize the said material;
translating means within the chamber operable to move the wafer vertically within the chamber;
a controller within the chamber to actuate the translating means, the controller being controllable from outside the chamber; and
a loader for loading the wafer into the chamber and onto the said pins.

The invention also provides a method of zone-melt recrystallization of a semiconductor material comprising:
inserting the semiconductor material to be crystallized into a processing chamber;
supporting the material with a lifter that contacts a surface of the material;
actuating a bearing within the chamber to translate the lifter that is secured to the bearing, and the material positioned on the lifter;
positioning the material on a support surface within the chamber adjacent to a heating element such that the material is contacted by the support surface along a peripheral portion of the material; and
crystallizing the material with the heating element.

Apparatus disclosed in detail hereinafter includes a flexure support bearing means which is employed to control the transport of the wafer above the platen on which the wafer rests during recrystallization. This transport assembly lowers and raises the wafer relative to the platen when the wafer is loaded or unloaded from the processing chamber.

The assembly hoists the wafer onto a loader after processing where the loader is removed from the chamber during recrystallization.

The transport assembly is comprised of at least three pins that contact the wafer during transport. These pins are mounted on a moveable plate whose motion must be precisely controlled to prevent contact with the heating elements and prevent slippage of the wafer. The plate is preferably supported by four flexure support members which are displaced from their stress free state by a pressurized bellows which moves the plate and its attached pins up during transport of the wafer.

The plate provides the force necessary to compress the bellows and lower the pins when the pressure within the bellows is released. The flexures are constructed to restrict the displacement of the pins in a linear direction and to resist radial or rotational forces exerted on the transfer assembly.

A reflective panel is placed above the upper strip heater to reflect radiation from the strip heater onto the surface of the material being recrystallized. Alternatively, the panel can be comprised of a heat absorbing material that absorbs and reradiates the energy back toward the wafer to more efficiently focus the thermal energy utilized during recrystallization. A further embodiment employs a reflective coating that lines one or more inner surfaces of the processing chamber.

A baffling system is used to thermally isolate the loader assembly from the chamber in which recrystallization occurs. A preferred embodiment utilizes a rotatable cylinder positioned between the chamber and the loader such that a slot extending through the cylinder provides access to the chamber. The cylinder is rotated to an open position permitting the insertion of the loader arm, and the wafer supported by the arm, through the slot and into the chamber. When the arm is retracted, the cylinder can be rotated to a closed position whereby the slot is prevented from transmitting heat into the loader assembly space.

The invention will now be described in more detail by way of example with reference to the accompanying drawings, in which:
Figure 1 is a schematic illustration of the zone-melt recrystallization and loader apparatus of the present invention;
Figure 2 is a cross-sectional view of the double cylinder loading port of the invention;
Figure 3 is a cross-sectional view of the platen, transfer and bellows apparatus;
Figure 4 is a perspective view of the flexure support design used to control motion of the pin transfer assembly;
Figure 5 is an exploded perspective partially sectioned view of the platen assembly;
Figure 5A is an enlarged cross-sectional view of the platen heater assembly;
Figure 6 is a perspective partially sectioned view of the zone-melt recrystallization apparatus of the present invention;
Figure 7 is a side view of the upper strip heater and energy directing panel;
Figure 8 is a perspective partially sectioned view of another preferred embodiment of the platen assembly;
Figure 9 is a perspective view of another preferred embodiment of the platen assembly using tabs to suspend the wafer;
Figure 10 is a perspective view of another preferred embodiment of the platen and transfer assembly wherein wires, which extend through parallel grooves on opposite sides of the platen, can be elevated above the platen to raise and lower the wafer;
Figure 11 is a top view of another preferred embodiment of the platen and transfer assembly wherein tabs positioned about the periphery of the platen are used to elevate the wafer above the platen;
Figure 12 is a top view of another preferred embodiment of the platen and transfer assembly where portions of the platen can be elevated to permit the loader to be inserted underneath the wafer and remove it from the processing chamber;
Figure 13 is a cross-sectional view of a radial heater assembly for the zone-melt recrystallization apparatus of the present invention; and
Figure 14 is a prespective view of a further heater assembly for the zone-melt recrystallization apparatus of the present invention.

### Detailed Description

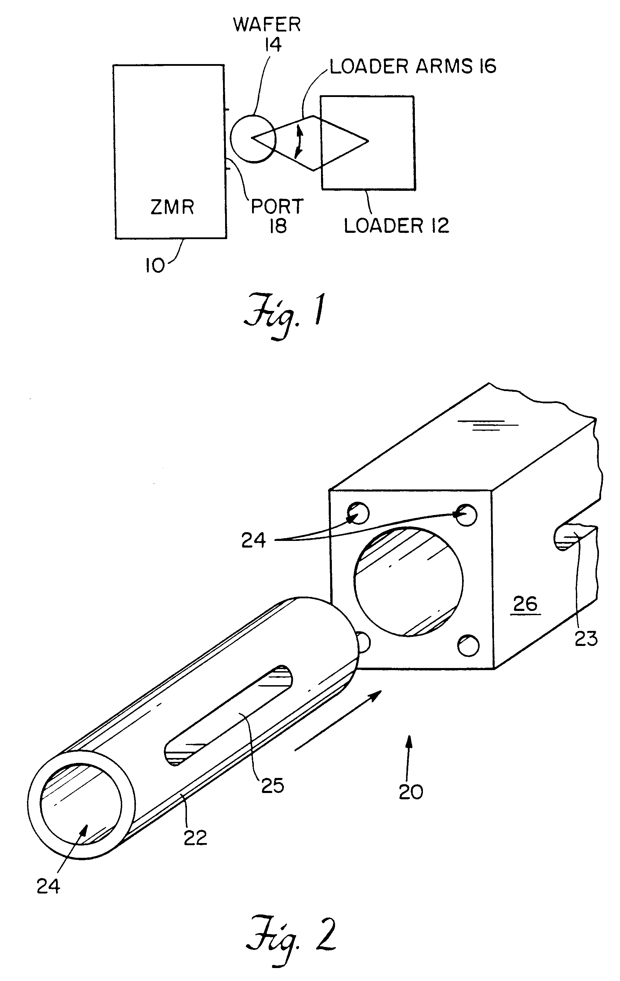

A schematic view of the zone-melt recrystallization and loader apparatus of the present invention is shown in Figure 1. The loader 12 is comprised of a pair of arms 16 that removes a silicon wafer 14 from a storage reservoir and transfers the wafer 14 through port 18 and into the chamber 10 where it is placed onto a heating element.

Figure 2 is a cross-sectional view of the port system 20. The port can be opened to permit insertion and removal of the wafer, and closed during recrystallization so that the loader is thermally isolated by the port apparatus. The port system 20 is comprised of an outer housing 26 and an inner cylinder 22 with the latter configured within the former. The inner cylinder 22 rotates to permit the closure of the port The inner cylinder 22 has a slot 25 extending through it such that when the slot 25 is aligned with slot 23, a wafer on the loader arms can be extended through the aligned slots and into the chamber.

The port apparatus 20 can be attached to a cooling system where a coolant 24 such as a circulating water flow is passed between the inner and outer cylinders. This insures the thermal isolation of the loader 12 from the chamber 10.

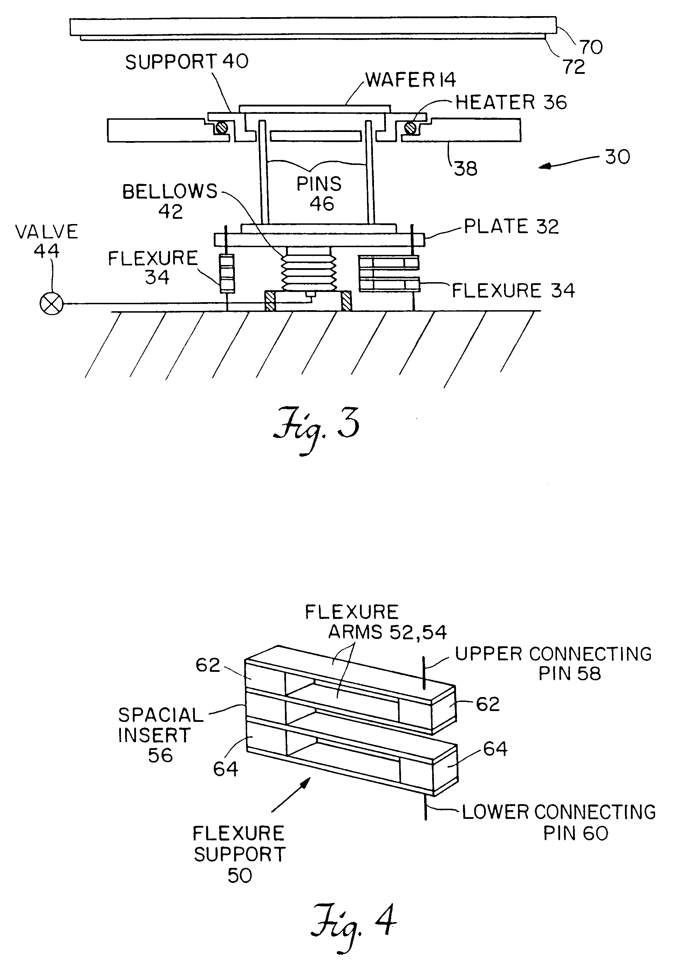

Figure 3 is a cross-sectional view of the bellows and flexure support system positioned within the chamber that is used to lower or elevate the wafer 14 relative to the platen assembly 38 during loading and unloading of the wafer from the chamber 10. The bellows 42 is supplied with a pressurized gas through a valve 44 located outside of the chamber 10 to lift pins 46 that pass through the heating system (not shown) and the platen assembly 38 to engage the wafer 14 and lift it off the platen so that the loader arms 16 can transport the wafer 14 out of the chamber 10.

This embodiment also employs a reflective material 72 that is positioned on an inner wall or surface 70 of the processing chamber. The surface 70, in one embodiment, is a window permitting viewing of the recrystallization process that, without a reflective coating, is a substantial thermal drain of the system.

There are four flexure supports 34 for the bellows assembly, one of which is shown in greater detail in Figure 4. Each flexure used to support and stabilize each corner of the plate to which the lower ends of the pins 46 are secured. Each flexure support 34 is comprised of two pairs of flexure arms. Each pair has two flexure arms 52 and 54 connected at both ends by spacial inserts 62 and 64. Each pair is then connected at a far end by a spacial insert 56. The far end of the flexure support is opposite the end at which the support is mounted onto the bellows apparatus by upper and lower connecting pins 58 and 60.

This pin lifter assembly 30 must be stable at high temperatures as it never leaves the ZMR chamber 10. The pins 46 must not perturb the temperature profile of the wafer 14 so that recrystallization is performed uniformly across the wafer with a minimum of defects. The pins 46 must move through the lower heater without touching the heating element. These pins 46 can preferably be comprised of small diameter quartz rods. The pins are mounted on a plate 32 that can be comprised of tantalum or a similar thermally stable material.

The flexure supports 34 act as a frictionless bearing and guide for the motion of the plate 32 and the attached pins 46. The upper and lower pairs of flexure arms about the central spacial insert 56 provide a small resistance to the up and down motion of the pins 46. The flexure supports 34 also provide a very stiff resistance to motion in the plane of the plate 32. Thus the flexure supports are designed to prevent translation or rotation of the pins 46 in the plane perpendicular to their up and down motion.

A preferred embodiment utilizes of a pair of flexure supports mounted on the same set of connecting pins at a 90° angle. This embodiment operates to more effectively prevent rotation of the plate 32.

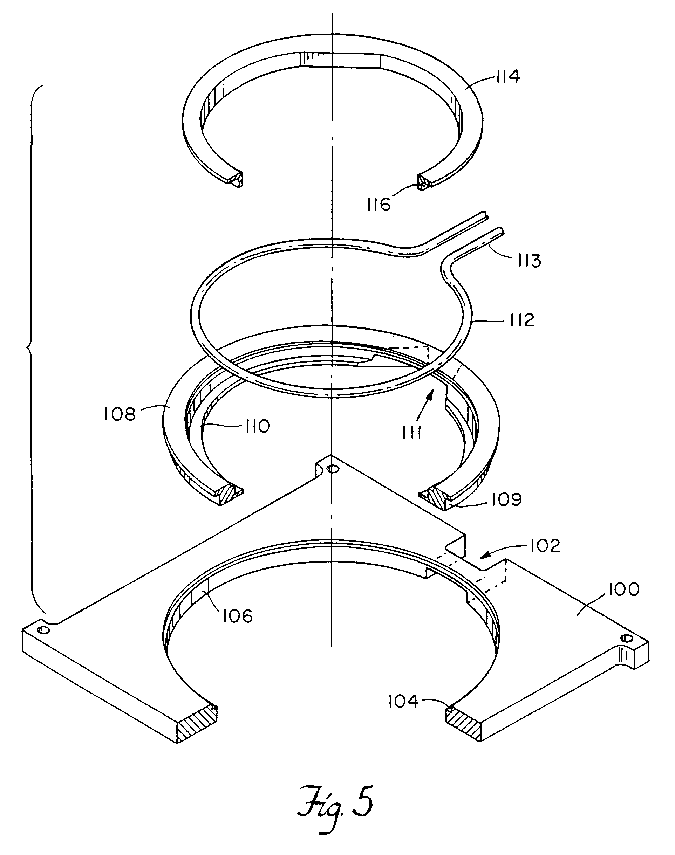

Figure 5 shows the components of a preferred embodiment of the platen assembly. Unlike the platen assembly shown in Figure 3, this embodiment does not have holes for the pins 46, but exposes almost the entire lower surface of the wafer 14 to the lower heater. An outer platen member 100 has an inner cylindrical wall 106 having an annular groove 104 along the top edge of wall 106. One side of the platen member 100 has an opening 102 through which the contact rods 113 of the platen heating element 112 extend. An annular ring 108 is positioned between the heating element 112 and the platen member 100 to provide a thermal break between these two components. An outer annular surface 109 of the ring 108 rests on the groove 104 of the platen member 100. The heating element 112 rests on an inner peripheral surface 110 of the ring 108. An opening 111 extends through a portion of the ring which is aligned with opening 102 to provide electrical contacts to the heating element 112. An inner support ring 114 is positioned between the wafer 14 and the heating element 112. A groove 116 in the outer wall of the support ring 114 fits loosely over the heating element 112.

Figure 5A illustrates a more detailed cross-sectional view of how the components of the embodiment of Figure 5 are positioned relative to each other. The heating element 112 rests on surface 105. A thermal break or space 103 is located between the support ring 114 and the annular ring 108.

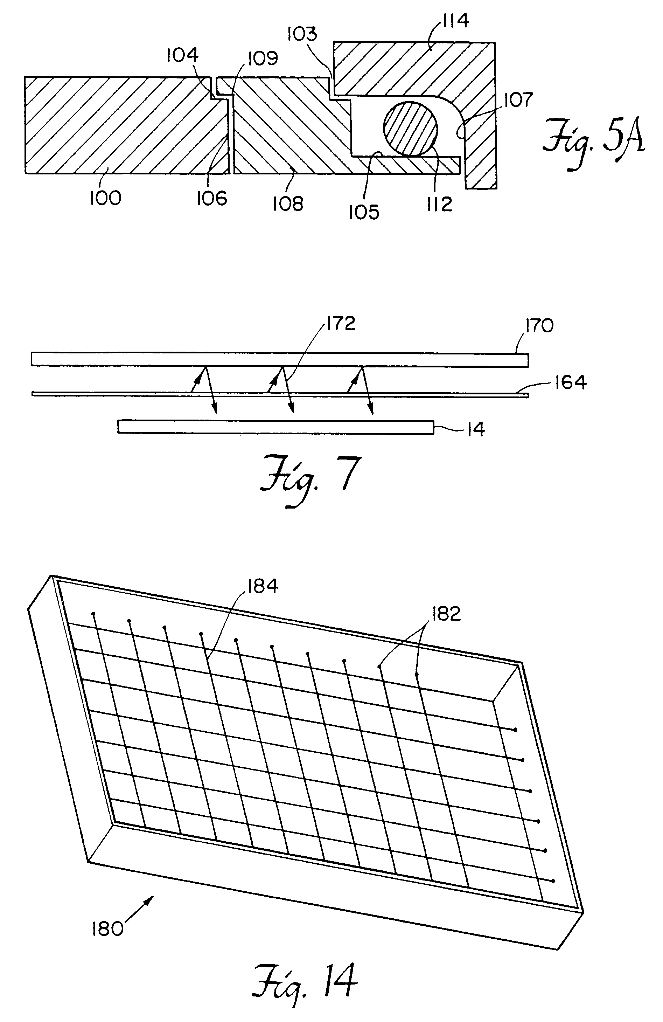

Figure 6 illustrates, in a partially sectioned perspective view, the configuration of the three heating elements and the transfer assembly relative to the platen 100 and wafer 14 supported thereon.

A lower heater 160, preferably comprised of a single graphite element, is positioned between the plate 32 that is supported by flexures 34. The flexures 34 are supported by a base plate 162. A heat shield (not shown) can be positioned between the plate 32 and heating element 160 to thermally isolate the bellows and flexure support systems. Holes 170 within the heating element 160 permit passage of the pins 46 so that they can be raised to contact and lift the wafer 14 after processing. The strip heater 164 is clamped to a frame 166 so that the heating element 164 can be translated relative to the wafer 14. The outer peripheral edge of the wafer rests on support ring 114 which is heated by element 112.

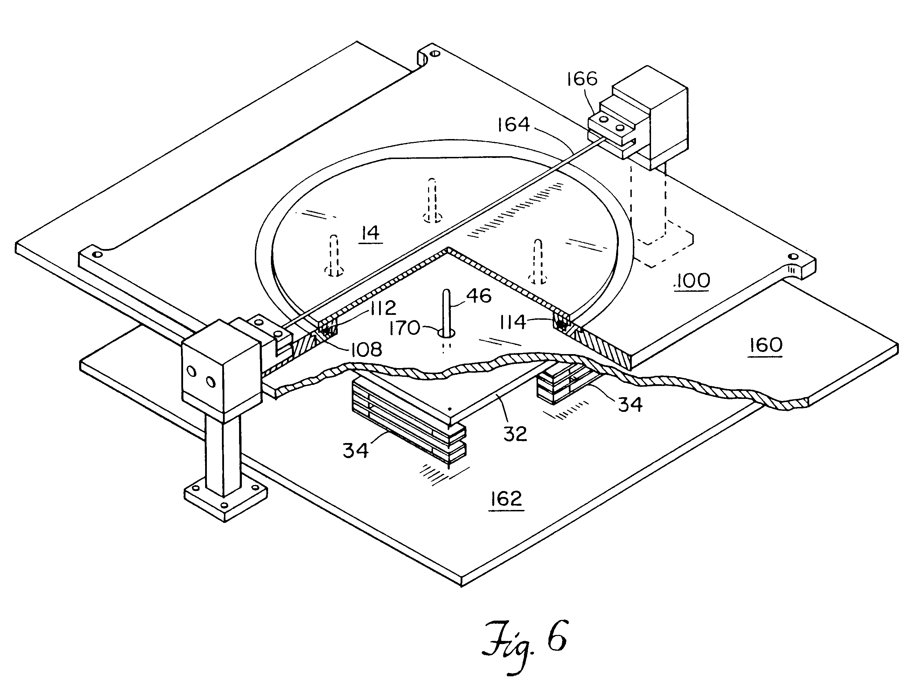

Figure 7 illustrates a side view of the strip heater 164 extending over the wafer 14 wherein a panel 170 is used to direct thermal radiation 172 that emanates from heater 164 away from the wafer 14 back onto the wafer thereby widening slightly the melt-zone on the wafer 14.

Figure 8 illustrates another preferred embodiment of the platen assembly where the support ring 40 has an opening 152 having sufficiently large dimensions to permit the loader arm 150 to be inserted through opening 152 and under the wafer 14 so that the wafer need not be lifted off the ring 40 by a separate transfer assembly.

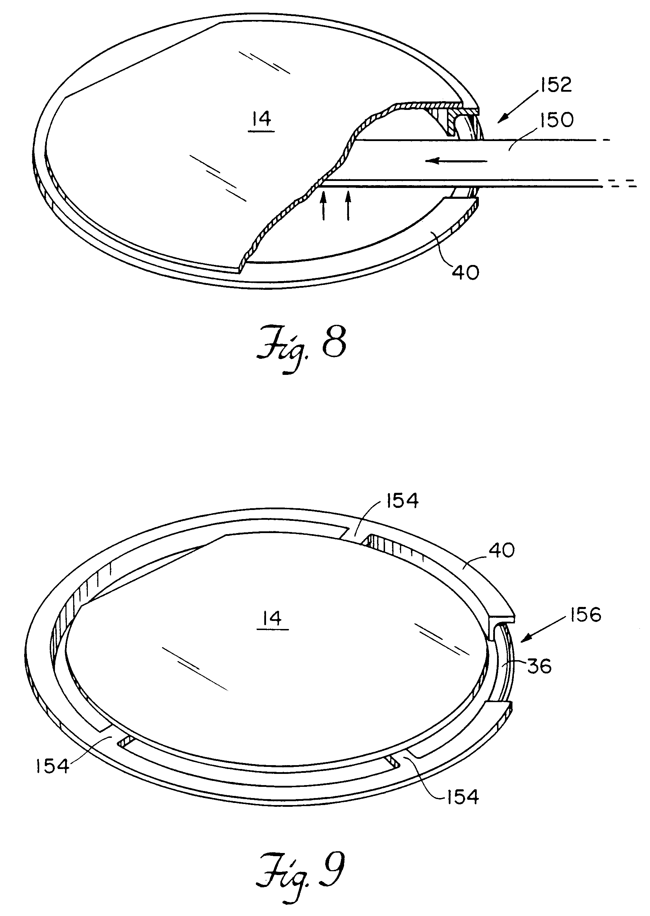

Figure 9 illustrates a further embodiment where three or more tabs 154 extending inwardly from ring 40 are used to support the wafer 14. This structure exposes most of the wafer 14 to the lower heater thereby minimizing thermal gradients at the rim of the wafer.

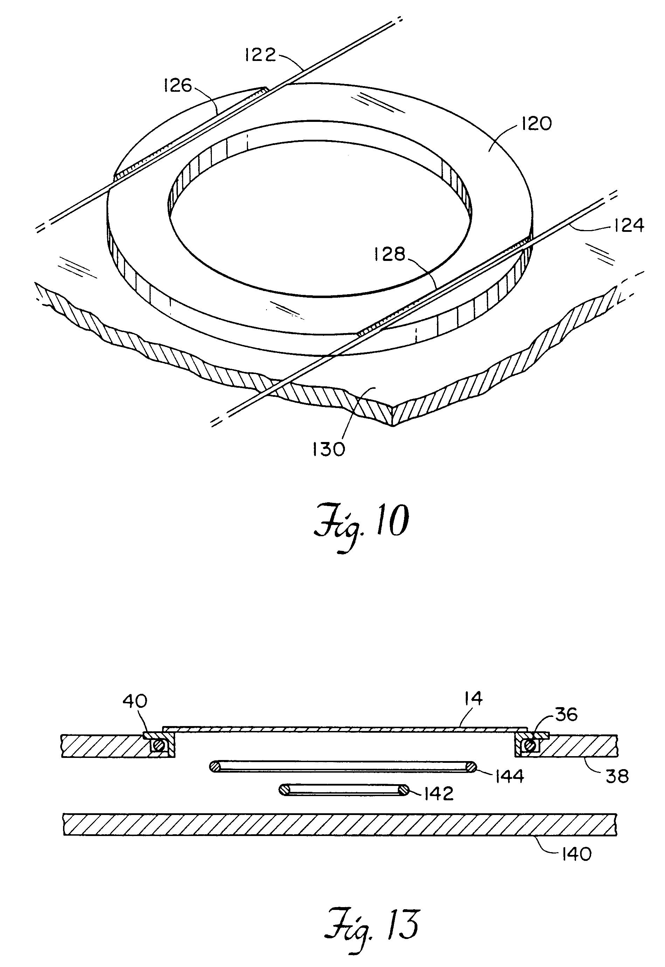

Figure 10 illustrates another preferred embodiment of the transfer assembly where parallel wires 122 and 124 extend through grooves 126 and 128 in the upper surface of support ring 120. The wires are spaced so that they can lower and raise the wafer 14 to permit the loader to insert or remove the wafer from the chamber 10.

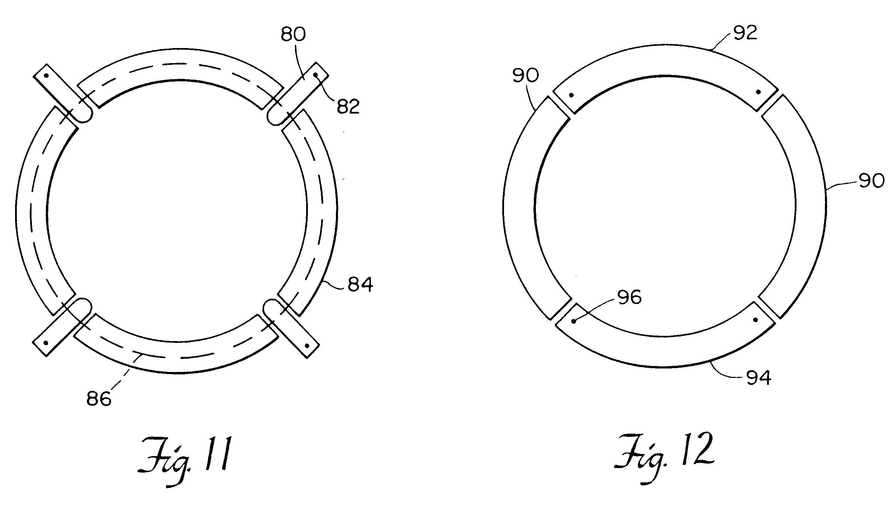

Figure 11 illustrates another preferred embodiment of the platen and transfer assemblies where a number of tabs 80, which are manipulated by pins 82, that extend under the edge 86 of the wafer 14. The pins can be raised and lowered relative to the platen 84 so that the wafer can be removed from the chamber.

Figure 12 illustrates a further preferred embodiment of the platen and transfer assemblies wherein two stationary portions of the platen 90 are separated by moveable portions 92 and 94 that can be raised and lowered relative to the stationary elements 90 by pins 96 to raise and lower the wafer 14.

The embodiments of the platen shown in Figures 8-12 result in systems for loading wafers into the chamber without the need for pins 46 which extend through the lower heater. Without the holes 170 in the lower heater 160 that are positioned directly beneath the wafer, a more uniform heat distribution is possible.

Even with the more uniform heat distribution resulting from the embodiments of Figures 8-12, there also exists a radial disparity in the heat distribution generated by the lower heater which is only partially offset by the circular platen heater 112.

Figure 13 illustrates another preferred embodiment in which one or more circular heaters 142 and 144 are positioned concentrically within the platen heater 36. This circular array of heating elements operates to correct for any uneven radial distribution of heat across the wafer.

Figure 14 illustrates another preferred embodiment in which the single element lower graphite heater 160 of Figure 6 is replaced by a multiple element array comprised of a grid 180 of graphite strips or wires 184. The array forms an x-y grid in which each heater can be individually controlled at contact points 182. With this arrangement, non-uniformities in the temperature distribution across the wafer could be compensated by applying different power levels to each heater.

## Claims

1. Apparatus for zone-melt recrystallization of a semiconductor wafer, comprising:
a processing chamber (10) to zone-melt recrystallize a semiconductor wafer (14) positioned in the chamber;
a platen within the chamber (10) which underlies a wafer (14) when loaded into the chamber and at least three pins (46, 82, 96) within the chamber which can support the wafer therein;
a first heater (36, 112, 160, 180) to heat the wafer (14) to a temperature below the melting temperature of the semiconductor material to be recrystallized;
a second heater (164) to heat a portion of the wafer (14) above said melting temperature such that a translatable melt zone is generated to continuously melt and recrystallize the said material;
translating means within the chamber (10) operable to move the wafer vertically within the chamber (10);
a controller (42) within the chamber to actuate the translating means, the controller being controllable from outside the chamber (10); and
a loader (12) for loading the wafer (14) into the chamber and onto the said pins (46).

2. Apparatus according to claim 1, wherein the first heater comprises a grid (180) of individually controlled heating elements (184).

3. Apparatus according to claim 1, further comprising a panel (70, 72) located to one side of the wafer (14) to reflect or re-radiate heat energy emitted by the second heater (164) toward the wafer.

4. Apparatus according to claim 3, wherein the panel (70, 72) comprises a thermally-absorbing material which absorbs radiant energy from the second heater (164) and re-transmits it towards the wafer (14).

5. Apparatus according to claim 1, wherein the translating means comprises a vertically movable plate (32) on which the said pins (46) are mounted.

6. Apparatus according to claim 5, wherein the controller of the translating means (32) comprises a bellows (42), and the apparatus further includes flexure support bearing means (34) for linearly directing displacement of the pins.

7. Apparatus according to claim 1, wherein the said pins (46) are movable by the translating means for raising the wafer (14) from the platen (38) or for lowering it onto the platen (38), the apparatus further including flexure support bearing means (34) to confine motion of the pins (46) to the vertical direction.

8. Apparatus according to any of claims 1 to 7, wherein the pins (46) are quartz rods.

9. Apparatus according to any of claims 1 to 8, wherein the translating means comprises a tantalum plate (32) on which the pins (46) are mounted.

10. The apparatus of claim 9 as dependent on either one of claims 6 and 7, wherein said flexure support bearing means (34) is comprised of a pair of arms attached at one end by a spacial insert (56) and wherein one arm is connected at the opposite end to the plate, and wherein the other arm is connected to a stationary lower support surface.

11. The apparatus of claim 10, wherein
(a) said flexure support bearing means operates as a bearing in which contacting components undergo substantially no movement relative to each other; or
(b) said pair of arms is mounted with a second pair of arms configured at a 90° angle from said first pair of arms; or
(c) each arm is comprised of a pair of flexible members (52, 54) connected at both ends by a spatial insert (62 or 64).

12. Apparatus according to claim 1 further including a port device between the chamber (10) and the loader (12), the port device being openable to allow the loader to insert a wafer (14) into the chamber (10) or to remove it therefrom, and closeable during recrystallization to thermally isolate the loader from heat generated inside the chamber.

13. The apparatus of claim 1, further including a rotatable elongated outer cylinder (26) with a slot (23) extending therethrough such that the loader, with a wafer supported by the loader can be inserted into the chamber (10) through the slot when the cylinder (26) is rotated to an open position and such that heat generated by the chamber (10) is isolated from the loader (12) when the cylinder is rotated to a closed position.

14. A method of zone-melt recrystallization of a semiconductor material comprising:
inserting the semiconductor material to be crystallized into a processing chamber;
supporting the material with a lifter that contacts a surface of the material;
actuating a bearing within the chamber to translate the lifter that is secured to the bearing, and the material positioned on the lifter;
positioning the material on a support surface within the chamber adjacent to a heating element such that the material is contacted by the support surface along a peripheral portion of the material; and
crystallizing the material with the heating element.

15. The method of claim 14,
(a) further comprising translating the material with the lifter from the support surface and removing the crystallized material from the chamber; or
(b) wherein the lifter comprises a plurality of pins; or
(c) wherein the bearing comprises a plurality of flexure supports secured to a plate on which the lifter is mounted.

## Patentansprüche

1. Vorrichtung zur Zonenschmelzrekristallisierung eines Halbleiter-Wafers, die folgendes umfaßt:
eine Arbeitskammer (10) zum Zonenschmelzrekristallisieren eines Halbleiter-Wafers (14), der in der Kammer liegt;
eine Trägerplatte innerhalb der Kammer (10), die unter einem Wafer (14) liegt, wenn er in die Kammer eingebracht wird, und wenigstens drei Stifte(46, 82, 96) innerhalb der Kammer, die den Wafer darin tragen können;
eine erste Heizeinrichtung (36, 112, 160, 180) zum Erhitzen des Wafers (14) auf eine Temperatur unterhalb der Schmelztemperatur des Halbleitermaterials, das rekristallisiert werden soll;
eine zweite Heizeinrichtung (164) zum Erhitzen eines Teils des Wafers (14) über die Schmelztemperatur derart, das eine verschiebbare Schmelzzone erzeugt wird, um das Material kontinuierlich zu schmelzen und zu rekristallisieren;
eine Verschiebungseinrichtung innerhalb der Kammer (10), die betreibbar ist, um den Wafer vertikal innerhalb der Kammer (10) zu bewegen;
eine Steuereinrichtung (42) innerhalb der Kammer, um die Verschiebungseinrichtung zu betätigen, wobei die Steuereinrichtung von der Außenseite der Kammer (10) steuerbar ist; und
eine Beschickungseinrichtung (12) zum Einbringen des Wafers (14) in die Kammer auf die besagten Stifte (46).

2. Vorrichtung nach Anspruch 1, bei der die erste Heizeinrichtung ein Gitter (180) aus einzeln gesteuerten Heizelementen (184) umfaßt.

3. Vorrichtung nach Anspruch 1, die weiterhin eine Platte (70, 72) umfaßt, die auf einer Seite des Wafers (14) gelegen ist, um von der zweiten Heizeinrichtung (164) abgestrahlte Wärmeenergie in Richtung auf den Wafer zu reflektieren oder zurückzustrahlen.

4. Vorrichtung nach Anspruch 3, bei der die Platte (70, 72) ein wärmeabsorbierendes Material umfaßt, das Strahlungsenergie von der zweiten Heizeinrichtung (164) absorbiert und in Richtung auf den Wafer (14) zurückschickt.

5. Vorrichtung nach Anspruch 1, bei der die Verschiebungseinrichtung eine vertikal bewegliche Platte (32) umfaßt, auf der die besagten Stifte (46) angebracht sind.

6. Vorrichtung nach Anspruch 5, bei der die Steuereinrichtung der Verschiebungseinrichtung (32) einen Balk (42) umfaßt und die Vorrichtung weiterhin eine Biegungsträger-Auflageeinrichtung (34) für linear gerichtete Verschiebung der Stifte einschließt.

7. Vorrichtung nach Anspruch 1, bei der die Stifte (46) durch die Verschiebungseinrichtung bewegbar sind zum Anheben des Wafers (14) von der Trägerplatte (38) oder zum Senken desselben auf die Trägerplatte (38) und die Vorrichtung weiterhin Biegungsträger-Auflageeinrichtungen (34) umfaßt, um die Bewegung der Stifte (46) auf die vertikale Richtung zu beschränken.

8. Vorrichtung nach einem der Ansprüche 1 bis 7, bei der die Stifte (46) Quarzstifte sind.

9. Vorrichtung nach einem der Ansprüche 1 bis 8, bei der die Verschiebungseinrichtung eine Tantalplatte (32) umfaßt, auf der die Stifte (46) montiert sind.

10. Die Vorrichtung nach Anspruch 9 und in Abhängigkeit von einem der Ansprüche 6 oder 7, bei der die Biegungsträger-Auflageeinrichtung (34) aus einem Paar Armen besteht, die an einem Ende durch ein Distanzstück (56) befestigt sind, und wobei ein Arm an dem entgegengesetzten Ende an der Platte befestigt ist und wobei der andere Arm mit einer unteren festen Trägerfläche verbunden ist.

11. Die Vorrichtung nach Anspruch 10, bei der
(a) die Biegungsträger-Auflageeinrichtung als ein Auflager wirkt, bei dem sich berührende Bauteile im wesentlichen keine Bewegung relativ zu einander durchführen; oder
(b) das besagte Paar Arme mit einem zweiten Paar Arme, die in einem Winkel von 90° gegen das erste Paar Arme ausgelegt sind, montiert sind; oder
(c) jeder Arm aus einem Paar biegsamer Glieder (52, 54) besteht, die an beiden Enden durch ein Distanzstück (62 oder 64) verbunden sind.

12. Vorrichtung nach Anspruch 1, die weiterhin eine Öffnungseinrichtung zwischen der Kammer (10) und der Beschickungseinrichtung (12) umfaßt, wobei die Öffnungseinrichtung geöffnet werden kann, um zu gestatten, daß die Beschickungseinrichtung einen Wafer (14) in die Kammer (10) einschiebt oder einen solchen aus ihr entnimmt, und während der Rekristallisierung schließbar ist, um die Beschickungseinrichtung gegen innerhalb der Kammer erzeugte Wärme thermisch zu isolieren.

13. Die Vorrichtung nach Anspruch 1, die weiterhin einen drehbaren langgestreckten äußeren Zylinder (26) mit einem Schlitz (23), der sich derart durch ihn hindurch erstreckt, daß die Beschickungseinrichtung mit einem von der Beschickungseinrichtung getragenen Wafer in die Kammer (10) durch den Schlitz eingeschoben werden kann, wenn der Zylinder (26) in eine offene Stellung gedreht wird, und derart, daß durch die Kammer (10) erzeugte Wärme gegen die Beschickungseinrichtung (12) isoliert wird, wenn der Zylinder in eine geschlossene Stellung gedreht wird, umfaßt.

14. Ein Verfahren zur Zonenschmelzrekristallisierung eines Halbleitermaterials, das folgendes umfaßt:
Einschieben des zu kristallisierenden Halbleitermaterials in eine Arbeitskammer;
Halten des Materials mit einer Hebeeinrichtung, die eine Oberfläche des Materials berührt;
Betätigen eines Lagers innerhalb der Kammer, um die Hebeeinrichtung, die an dem Lager befestigt ist, und das auf der Hebeeinrichtung positionierte Material zu verschieben;
Positionieren des Materials auf einer Trägerfläche innerhalb der Kammer angrenzend an ein Heizelement derart, daß das Material durch die Trägerfläche entlang eines periphären Abschnitts des Materials berührt wird; und
Kristallisieren des Materials mit dem Heizelement.

15. Das Verfahren nach Anspruch 14,
(a) das weiterhin das Verschieben des Materials mit der Hebeeinrichtung von der Trägerfläche und das Entfernen des kristallisierten Materials aus der Kammer umfaßt; oder
(b) bei dem die Hebeeinrichtung eine Vielzahl von Stiften umfaßt; oder
(c) bei dem das Lager eine Vielzahl von Biegungsträgern umfaßt, die an einer Platte befestigt sind, auf der die Hebeeinrichtung angebracht ist.

## Revendications

1. Appareil pour la recristallisation d'une zone a fusion d'une tranche de semi-conducteur comprenant une chambre de traitement (10) pour recristalliser la zone en fusion d'une tranche de semi-conducteur (14) placée dans la chambre, une platine dans la chambre (10) laquelle se trouve en dessous d'une tranche (14) lorsque celle-ci est chargée dans la chambre, et au moins trois doigts (46,82,96) dans la chambre lesquels peuvant supporter la tranche dans cette chambre, un premier élément chauffant (36,112,160,180) pour chauffer la tranche (14) à une température inférieure à la température de fusion du matériau semi-conducteur devant être recristallisé, un second élément chauffant (164) pour chauffer une portion de la tranche (14) au-dessus de la température de fusion de telle façon qu'une zone a fusion pouvant être déplacée en translation sort produite, afin de faire fondre et de recristalliser d'une manière continue le matériau, un moyen de déplacement a translation dans la chambre (10) pouvant intervenir pour déplacer la tranche verticalement dans la chambre (10), un organe de commande (42) dans la chambre pour actionner le moyen de déplacement en translation, cet organe de commande étant commandé à partir de l'extérieur de la chambre (10), et un chargeur (12) pour charger la tranche (14) vers et dans la chambre et sur les doigts (46).

2. Appareil suivant la revendication 1 caractérisé en ce que le premier élément chauffant comprend une grille (180) d'éléments chauffants (184) commandés individuellement.

3. Appareil suivant la revendication 1 caractérisé en ce qu'il comprend en outre un panneau (70,72) disposé d'un côté de la tranche (14) de manière à réfléchir ou à rayonner en retour, en direction de la tranche, l'énergie thermique émise par le second élément chauffant (164).

4. Appareil suivant la revendication 3 caractérisé en ce que le panneau (70,72) est constitué d'un matériau absorbant la chaleur lequel absorbe l'énergie rayonnée à partir du second élément chauffant (164) et la retransmet en direction de la tranche (14).

5. Appareil suivant la revendication 1 caractérisé en ce que le moyen de déplacement en translation comprend une plaque (32) mobile verticalement et sur laquelle sont montés les doigts (46).

6. Appareil suivant la revendication 5 caractérisé en ce que l'organe de commande du moyen de déplacement en translation (32) est constitué par un soufflet (42) et l'appareil comporte en outre un moyen formant un palier support flexible (34) afin de diriger linéairement le déplacement des doigts.

7. Appareil suivant la revendication 1 caractérisé en ce que les doigts (46) peuvent être déplacés par le moyen de déplacement en translation de manière à soulever la tranche (14) à partir de la platine (38) ou bien à l'abaisser sur cette platine (38), l'appareil comportant en outre un moyen (34) formant un palier support flexible afin de limiter le mouvement des doigts (46) à la direction verticale.

8. Appareil suivant l'une quelconque des revendications 1 à 7 caractérisé en ce que les doigts (46) sont des tiges de quartz.

9. Appareil suivant l'une quelconque des revendications 1 à 8 caractérisé en ce que le moyen de déplacement en translation comprend une plaque en tantale (32) sur laquelle sont montés les doigts (46).

10. Appareil suivant la revendication 9 telle que dépendant de l'une ou l'autre des revendications 6 et 7 caractérisé en ce que le moyen (34) formant palier support flexible est constitué d'une paire de bras attachés l'un à l'autre, à une extrémité, au moyen d'une entretoise spatiale (56), l'un des bras étant relié, à l'extrémité opposée, à la plaque tandis que l'autre bras est relié à une surface support inférieure stationnaire.

11. Appareil suivant la revendication 10 caractérisé en ce que :
(a) le moyen formant palier support flexible fonctionne en tant que palier dans lequel les composants en contact ne subissent pratiquement aucun mouvement l'un par rapport à l'autre; ou bien
(b) la paire de bras est montée avec une seconde paire de bras formant un angle de 90° par rapport à la première paire de bras; ou bien
(c) chaque bras est constitué d'une paire d'éléments flexibles (52,54) reliés entre eux, à leurs deux extrémités, par une entretoise spatiale (62 ou 64).

12. Appareil suivant la revendication 1 caractérisé en ce qu'il comporte en outre un dispositif à orifice entre la chambre (10) et le chargeur (12), ce dispositif à orifice pouvant être ouvert de manière à permettre au chargeur d'introduire une tranche (14) dans la chambre (10) ou bien de l'enlever de cette chambre, et pouvant être fermé pendant la recristallisation afin d'isoler thermiquement le chargeur de la chaleur produite à l'intérieur de la chambre.

13. Appareil suivant la revendication 1 caractérisé en ce qu'il comporte en outre un cylindre externe allongé et rotatif (26) pourvu d'une fente (23) s'étendant à travers lui de telle façon que le chargeur, avec une tranche supportée par ce chargeur, puisse être inséré vers et dans la chambre (10) en passant à travers la fente lorsque le cylindre (26) est tourné dans une position ouverte, et que la chaleur produite par la chambre (10) soit isolée du chargeur (12) lorsque le cylindre est tourné dans une position fermée.

14. Procédé de recristallisation d'une zone en fusion d'un matériau semi-conducteur comprenant les étapes consistant à insérer le matériau semi-conducteur devant être recristallisé dans une chambre de traitement, à supporter le matériau au moyen d'un élévateur qui vient en contact avec une surface du matériau, à actionner un appui dans la chambre afin de déplacer l'élévateur qui est fixé à l'appui, et le matériau placé sur l'élévateur, à disposer le matériau sur une surface support dans la chambre à proximité immédiate d'un élément chauffant de telle façon que le matériau soit en contact avec la surface support le long d'une portion périphérique du matériau, et à cristalliser le matériau au moyen de l'élément chauffant.

15. Procédé suivant la revendication 14 caractérisé en ce que :
(a) il comprend en outre l'étape consistant à déplacer en translation le matériau avec l'élévateur à partir de la surface support et à enlever le matériau cristallisé de la chambre; ou bien
(b) l'élévateur comprend se pluralité de doigts; ou bien
(c) l'appui est constitué d'une pluralité de supports flexibles fixés à une plaque sur laquelle est monté l'élévateur.
